# Europäisches Patentamt

# European Patent Office

# Office européen des brevets

(11) Veröffentlichungsnummer: **0 076 984**
**B1**

(12) **EUROPÄISCHE PATENTSCHRIFT**

(12)

(45) Veröffentlichungstag der Patentschrift:
07.01.87

(21) Anmeldenummer: **82109086.7**

(22) Anmeldetag: **01.10.82**

(51) Int. Cl.⁴: **G 03 F 7/26**

(30) Priorität: **09.10.81 DE 3140186**

(43) Veröffentlichungstag der Anmeldung:
**20.04.83 Patentblatt 83/16**

(45) Bekanntmachung des Hinweises auf die Patenterteilung:
**07.01.87 Patentblatt 87/2**

(84) Benannte Vertragsstaaten:
**AT BE CH DE FR GB IT LI NL SE**

(56) Entgegenhaltungen:
**WO - A - 79/00593
DE - A - 2 504 130
DE - A - 3 008 824
US - A - 3 201 241
US - A - 3 891 439
US - A - 4 147 545**

**Die Akte enthält technische Angaben, die nach dem
Eingang der Anmeldung eingereicht wurden und die
nicht in dieser Patentschrift enthalten sind.**

(54) Entwickler und Verfahren zum Entwickeln für belichtete negativ-arbeitende Reproduktionsschichten.

(73) Patentinhaber: **HOECHST AKTIENGESELLSCHAFT,
Postfach 80 03 20, D-6230 Frankfurt am Main 80 (DE)**

(72) Erfinder: **Frass, Werner, Dr., Erbsenacker 37,
D-6200 Wiesbaden (DE)**
Erfinder: **Schell, Loni, Erbacher Strasse 10,
D-6238 Hofheim-Wallau (DE)**
Erfinder: **Gross, Inge, Am Heiligenhaus 27,
D-6204 Taunusstein 4 (DE)**

## Beschreibung

Die Erfindung betrifft einen Entwickler, der zum Entwickeln von negativ-arbeitenden belichteten Reproduktionsschichten geeignet ist, die auch ein organisches Bindemittel enthalten können.

Lichtempfindliche Reproduktionsschichten werden beispielsweise bei der Herstellung von Offsetdruckformen oder von Photoresists (beides im weiteren Kopiermaterialien genannt) verwendet, d.h. sie werden im allgemeinen vom Verbraucher oder vom industriellen Hersteller auf einen Schichtträger aufgebracht. Als Schichtträger in diesen Kopiermaterialien werden Metalle wie Zink, Magnesium, Chrom, Kupfer, Messing, Stahl, Silicium, Aluminium oder Kombinationen dieser Metalle, Kunststoffolien, Papier oder ähnliche Materialien eingesetzt. Diese Schichtträger können ohne eine modifizierende Vorbehandlung, bevorzugt aber nach Durchführung einer Oberflächenmodifizierung wie einer mechanischen, chemischen und/oder elektrochemischen Aufrauhung, einer Oxidation und/oder einer Behandlung mit Hydrophilierungsmitteln (z.B. bei Trägern für Offsetdruckplatten) mit der lichtempfindlichen Reproduktionsschicht beschichtet werden. Die üblichen Reproduktionsschichten enthalten neben mindestens einer lichtempfindlichen Verbindung meist noch ein organisches Bindemittel (Harze o. ä.) und gegebenenfalls auch noch Weichmacher, Pigmente, Farbstoffe, Netzmittel, Sensibilisatoren, Haftvermittler, Indikatoren und andere übliche Hilfsmittel. Die Reproduktionsschichten werden nach ihrer Belichtung entwickelt, um aus ihnen ein Bild zu erzeugen, beispielsweise wird so eine Druckform oder ein Photoresist erhalten.

Ein Entwickler für negativ-arbeitende Reproduktionsschichten muss die nicht von elektromagnetischer Strahlung (z.B. Licht) getroffenen Schichtteile (die späteren Nichtbildstellen) aus der belichteten Schicht herauslösen können, ohne dabei die von der Strahlung getroffenen Teile (die späteren Bildstellen) der Schicht wesentlich zu beeinflussen. In der als ein repräsentatives Beispiel zu nennenden DE-A-2 065 732 ( = US-A-3 867 147) werden als geeignete Entwickler beispielsweise aufgeführt: Wasser, Wasser/organische Lösemittel-Gemische, wässrige Salzlösungen, wässrige Säurelösungen, wässrig-alkalische Lösungen und unverdünnte organische Lösemittel, denen gegebenenfalls Tenside und/oder Hydrophilierungsmittel zugesetzt werden können. Die in den dortigen Beispielen hauptsächlich eingesetzten Entwickler enthalten Wasser, Na-laurylsulfat, Na-sulfat, Weinsäure und gegebenenfalls Benzylalkohol; andere Entwickler enthalten oder bestehen aus Isopropanol, n-Propanol, n-Propylacetat, Polyacrylsäure, 1,1,1-Trichlorethan, Aceton oder Ethylenglykolmonomethylether. Die am besten wirksamen Entwickler für solche negativ arbeitenden Reproduktionsschichten enthalten aber bisher in der Regel Tenside, so dass insbesondere bei einer maschinellen Entwicklung ein Aufschäumen des Entwicklers auftritt. Neben den bereits erwähnten Entwicklerkomponenten sind auch noch folgende aus dem Stand der Technik bekanntgeworden:

In der DE-B-1 193 366 ( = US-A-3 201 241) wird ein wässriger Entwickler für positiv-arbeitende Reproduktionsschichten beschrieben, der neben einer alkalisch wirkenden Komponente und einem Kation wie $Be^{2+}$, $Hg^{2+}$, $Ca^{2+}$, $Sr^{2+}$, $Ba^{2+}$, $Bi^{3+}$ oder $La^{3+}$ (als Anionen u.a. auch solche von aliphatischen Carbonsäuren genannt) noch Komplexbildner und/oder hydrophile Polymere enthält. Als Komplexbildner wird in einer grösseren Aufzählung von Verbindungen auch Salicylsäure (2-Hydroxybenzoesäure) genannt; die Entwickler sollen pH-Werte von 10,5 bis 12,2, vorzugsweise von 10,9 bis 11,5 aufweisen. Die Komplexbildner sollen in einer Menge von 0,001 bis 0,25 Gew.-%, vorzugsweise von 0,07 bis 0,1 Gew.-% im Entwickler vorhanden sein.

Aus der DE-A-2 353 992 ( = US-A-4 147 545) ist ein wässriger Entwickler für negativ- oder positiv-arbeitende Reproduktionsschichten bekannt, der ein Lithiumsalz einer aciden organischen Verbindung und/oder ein amphoteres Tensid enthält. Als geeignete Lithiumsalze werden in einer umfangreichen Aufzählung u.a. auch Li-benzoat, Li-naphthenat und Li-acetylsalicylat genannt.

Das Verfahren zum Entwickeln von positiv- oder negativ-arbeitenden Reproduktionsschichten gemäss der DE-A-2 504 130 wird bei Temperaturen von 35° bis 80°C mit Entwicklern durchgeführt, deren Komponenten einen Siedepunkt ($K_{P\,760}$) von mehr als 80°C aufweisen. Der Entwickler kann u.a. ein organisches Lösemittel, eine alkalisch wirkende Komponente, ein anionogenes oder nichtionogenes Tensid, Wasser und/oder ein Antischaummittel enthalten, wobei zu den letzteren u.a. auch Benzoesäure in einem Anteil von 0,1 bis 5 Gew.-% gezählt wird.

In der DE-A-2 934 897 ( = WO-A-79/00593) wird eine Desensibilisierungslösung für negativ-arbeitende Reproduktionsschichten beschrieben, die a) 2 bis 50 Gew.-% einer substituierten Benzoesäure, einer substituierten Benzolsulfonsäure oder -phosphonsäure oder eines entsprechenden Salzes dieser Säuren und b) 5 bis 60 Gew.-% eines Filmbildners aus der Gruppe aliphatischer Polyole, deren Monoester oder Alkalisalze enthält. Als geeignete Komponenten a) werden Nabenzoat, 4-Hydroxybenzoesäure oder das Kalium- oder Natriumsalz der 4-Aminobenzoesäure genannt; die Desensibilisierungslösung soll auch als Entwickler für die genannten Schichten geeignet sein.

Aus der EP-A-0 033 232 ist ein Entwickler für negativ-arbeitende Reproduktionsschichten bekannt, der a) 20 bis 300 g/l eines Salzes einer aliphatischen Carbonsäure mit bis zu 9 C-Atomen, b) ein nichtionogenes Tensid und gegebenenfalls c) 20 bis 300 g/l eines Salzes einer aromatischen Carbonsäure enthält; als geeignete Komponente c) werden Salze von Benzoesäure oder Toluolcarbonsäure genannt.

Die DE-A-3 008 824 beschreibt eine flüssige Zubereitung zum Behandeln lichtempfindlicher Laminate, welche eine alkohollösliche Polyamidschicht auf einem Substrat aufweisen, die

12 bis 70 Gew.-Teile eines aromatischen Neutralsalzes,

0,01bis 10 Gew.-Teile eines Alkalis,

1 bis 15 Gew.-Teile eines Alkohols und

84 bis 100 Gew.-Teile Wasser

enthalten. Die Photoresists, die entwickelt werden sollen, enthalten als lichtempfindliche Substanzen Mono- oder Biazide.

Viele der bekannten Entwickler haben aber entweder den Nachteil eines relativ hohen pH-Wertes, wodurch z.B. die auf vielen Druckplattenträgermaterialien vorhandenen Aluminiumoxidschichten angegriffen werden können, oder sie enthalten organische Lösemittel, wodurch eine umweltfreundliche Entwicklung nicht in optimaler Weise gewährleistet ist. Die bisher bekanntgewordenen Salze von aliphatischen oder aromatischen Carbonsäuren können zwar einige Reproduktionsschichten entwickeln, es treten jedoch insbesondere bei Bindemittel enthaltenden Schichten Probleme auf. Die Zugabe von bestimmten Tensiden kann zwar für den Entwicklungsvorgang hilfreich sein, dies gilt insbesondere für von der Hand oder in Küvetten zu entwickelnde Reproduktionsschichten, aber bei Einsatz dieser Entwickler in automatischen Entwicklungsmaschinen treten oftmals Schäumungseffekte auf.

Aufgabe der vorliegenden Erfindung ist es deshalb, einen wässrigen Entwickler für negativ-arbeitende Reproduktionsschichten mit einer lichtempfindlichen Schicht auf der Basis eines Diazoniumsalz-Polykondensationsproduktes oder eines polymeren Acrylsäure- oder Methacrylsäurederivats vorzuschlagen, der keine Zusätze von organischen Lösemitteln benötigt, auch für organische Bindemittel enthaltende Schichten geeignet ist und keine oder nur eine geringe Schäumungstendenz zeigt.

Die Erfindung geht aus von einem wässrigen Entwickler zum Entwickeln lichtempfindlicher, negativ arbeitender, gegebenenfalls ein organisches Bindemittel enthaltender Reproduktionsschichten mit einer lichtempfindlichen Substanz auf der Basis eines Diazoniumsalz-Polykondensationsproduktes oder eines polymeren Acrylsäure- oder Methacrylsäurederivates, dessen kennzeichnendes Merkmal darin besteht, dass der Entwickler neben Wasser 5 bis 60 Gew.-% mindestens eines Salzes von aromatischen Carbonsäuren enthält, deren Substituenten unmittelbar der Carboxylgruppe benachbart sind, wobei die Substituenten eine Aminogruppe, eine Hydroxygruppe und/oder Chlor oder Brom darstellen und der Entwickler frei von organischen Lösemitteln ist.

In einer bevorzugten Ausführungsform enthält der erfindungsgemässe Entwickler 10 bis 30 Gew.-% an den genannten Salzen. Zu den geeigneten Salzen gehören solche von Monocarbonsäuren, insbesondere von 2-Hydroxybenzoesäure (= Salicylsäure), 2-Aminobenzoesäure (= Anthranilsäure), 2-Chlorbenzoesäure, 2,6-Dihydroxybenzoesäure und von 2-Hydroxy-naphthalin-3-carbonsäure. Als Kation für diese möglichst wasserlöslichen Salze kommen insbesondere $Na^+$-, $NH_4^+$- oder $K^+$-Ionen in Betracht, aber auch Kationen, die sich von organischen Aminen wie Ethanolaminen oder Ethylendiamin ableiten.

Als weitere Komponenten, die aber für die grundsätzliche Entwicklungswirkung des erfindungsgemässen Entwicklers nicht zwingend erforderlich sind, kann der wässrige Entwickler auch nichtionogene und insbesondere anionogene Tenside in einer Menge von 0,01 bis 10 Gew.-% und Hilfsstoffe wie Komplexbildner (Sequestriermittel) oder Entschäumer enthalten. Als geeignete Tenside, die teilweise zur Vergleichmässigung und Beschleunigung des Entwicklungsvorgangs dienen können, haben sich insbesondere Alkali- oder Ammoniumsalze der Schwefelsäuremonoalkylester mit Alkylgruppen von $C_7$ bis $C_{14}$ herausgestellt. Zu den Komplexbildnern, die z.B. eventuell auftretende mehrwertige Kationen (z.B. $Ca^{2+}$) im Wasser daran hindern können, negativen Einfluss («Kalkseifen»-Bildung) auf die Salze der substituierten aromatischen Carbonsäuren zu nehmen, gehören insbesondere Phosphate (z.B. Polyphosphate), es sind aber auch andere Komplexbildner wie Citronensäure oder Ethylendiamintetraessigsäure möglich. Der pH-Wert des erfindungsgemässen Entwicklers weist im allgemeinen Werte zwischen 7 und 13, vorzugsweise zwischen 7 und 11, auf. Zur Einstellung des pH-Werts bei bereits vorgegebenen Salzen der substituierten aromatischen Carbonsäure und/oder zur Überprüfung vorgegebener Säure in die entsprechenden Salzformen können die verschiedensten basisch reagierenden Verbindungen eingesetzt werden, dazu zählen insbesondere die wässrigen Lösungen von Alkalihydroxiden, Ethanolaminen, Ethylendiamin, Alkaliphosphaten oder -polyphosphaten.

Eine weitere Lösung der gestellten Aufgabe ist ein Verfahren zum Entwickeln von lichtempfindlichen, negativ-arbeitenden gegebenenfalls ein organisches Bindemittel enthaltenden Reproduktionsschichten mit einer lichtempfindlichen Substanz auf der Basis eines Diazoniumsalz-Polykondensationsproduktes oder eines polymeren Acrylsäure- oder Methacrylsäurederivates, wobei man die Schicht belichtet und anschliessend entwickelt, dessen kennzeichnendes Merkmal darin besteht, dass man die Reproduktionsschicht mit einem Entwickler behandelt, der neben Wasser 5 bis 60 Gew.-% mindestens eines Salzes von aromatischen Carbonsäuren enthält, deren Substituenten unmittelbar der Carboxylgruppe benachbart sind, wobei die Substituenten eine Aminogruppe, eine Hydroxygruppe und/oder Chlor oder Brom darstellen und der Entwickler frei von organischen Lösungsmitteln ist. Insbesondere wird das Verfahren für die Entwicklung von solchen Reproduktionsschichten eingesetzt, die ein polymeres organisches Bindemittel mit Acetal-, Anhydrid-, Amid- (insbesondere Ureylen-) und/oder Carboxylgruppen bzw. als lichtempfindliche Verbindung ein Diazoniumsalz-Polykondensationsprodukt enthalten. Zu den genannten Bindemitteln zählen beispielsweise Mischpolymerisate aus Styrol und Maleinsäureanhydrid, Polyvinylbutyrale, Polyvinylformale, Umsetzungsprodukte aus polymeren Polyhydroxyverbindungen und Sulfonylisocyanaten, Mischpolymerisate aus Methylmethacrylat und Methacrylsäure oder Harnstoffharze.

Die erfindungsgemässen Entwickler sind dazu geeignet, auch polymere organische Bindemittel enthaltende negativ-arbeitende Reproduktionsschichten sauber aufzuentwickeln, ohne dass es zu einem Angriff oder einer Unterwanderung der Bildstellen kommt. Ausserdem treten keine grösseren Umweltprobleme, z.B. durch destillative Aufarbeitung von organischen Lösemittelanteilen auf, und die erfindungsgemässen Entwickler lassen sich zumindest ohne grösseres Schaumauftreten auch in automatischen Verarbeitungsmaschinen einsetzen. Die Entwickler lassen sich auch bereits bei pH-Werten anwenden, die nahe beim Neutralpunkt liegen.

Die zu entwickelnde Reproduktionsschicht liegt insbesondere als Teil (lichtempfindliche Schicht) einer Offsetdruckplatte oder als auf ein Trägermaterial aufgebrachter Resist (Photoresistschicht) vor. Als Trägermaterialien kommen beispielsweise solche auf der Basis von Zink, Chrom, Magnesium, Kupfer, Messing, Stahl, Silicium, Aluminium oder Kombinationen dieser Metalle in Frage oder auch Kunststofffolien, Papier oder damit vergleichbare Materialien. Diese können ohne eine spezielle modifizierende Vorbehandlung mit einer geeigneten Reproduktionsschicht versehen werden, bevorzugt wird diese Beschichtung jedoch erst nach einer Oberflächenmodifizierung wie einer mechanischen, chemischen oder elektrochemischen Aufrauhung, einer Oxidation und/oder einer Behandlung mit Hydrophilierungsmitteln (insbesondere bei Trägern für Offsetdruckplatten) durchgeführt.

Als besonders geeignete Substrate zur Herstellung von Offsetdruckplatten zählen solche aus Aluminium oder einer seiner Legierungen. Dazu gehören beispielsweise:
– «Reinaluminium» (DIN-Werkstoff Nr. 3.0255), d.h. bestehend aus $\geq$ 99,5% Al und den folgenden zulässigen Beimengungen von (maximale Summe von 0,5%) 0,3% Si, 0,4% Fe, 0,03% Ti, 0,02% Cu, 0,07% Zn und 0,03% Sonstigem, oder
– «Al-Legierung 3003» (vergleichbar mit DIN-Werkstoff Nr. 3.0515), d.h. bestehend aus $\geq$98,5% Al, den Legierungsbestandteilen 0 bis 0,3% Mg und 0,8 bis 1,5% Mn und den folgenden zulässigen Beimengungen von 0,5% Si, 0,5% Fe, 0,2% Ti, 0,2% Zn, 0,1% Cu und 0,15% Sonstigem.

Die in der Praxis sehr häufig anzutreffenden Aluminiumträgermaterialien für Druckplatten werden im allgemeinen vor Aufbringen der lichtempfindlichen Schicht noch mechanisch (z.B. durch Bürsten und/oder mit Schleifmittel-Behandlungen), chemisch (z.B. durch Ätzmittel) oder elektrochemisch (z.B. durch Wechselstrombehandlung in wässrigen HCl- oder $HNO_3$-Lösungen) aufgerauht. Die mittlere Rauhtiefe $R_z$ der aufgerauhten Oberfläche liegt dabei im Bereich von etwa 1 bis 15 µm, insbesondere im Bereich von 4 bis 8 µm.

Die Rauhtiefe wird nach DIN 4768 in der Fassung vom Oktober 1970 ermittelt, die Rauhtiefe $R_z$ ist dann das arithmetische Mittel aus den Einzelrauhtiefen fünf aneinandergrenzender Einzelmessstrecken.

Nach dem bevorzugt angewendeten elektrochemischen Aufrauhverfahren schliesst sich dann in einer weiteren, gegebenenfalls anzuwendenden Verfahrensstufe eine anodische Oxidation des Aluminiums an, um beispielsweise die Abriebs- und Haftungseigenschaften der Oberfläche des Trägermaterials zu verbessern. Zur anodischen Oxidation können die üblichen Elektrolyte wie $H_2SO_4$, $H_3PO_4$, $H_2C_2O_4$, Amidosulfonsäure, Sulfobernsteinsäure, Sulfosalicylsäure oder deren Mischungen eingesetzt werden. Es wird beispielsweise auf folgende Standardmethoden für den Einsatz von $H_2SO_4$ enthaltenden wässrigen Elektrolyten für die anodische Oxidation von Aluminium hingewiesen (s. dazu z.B. M. Schenk, Werkstoff Aluminium und seine anodische Oxydation, Francke Verlag – Bern, 1948, Seite 760; Praktische Galvanotechnik, Eugen G. Leuze Verlag – Saulgau, 1970, Seiten 395 ff und Seiten 518/519; W. Hübner und C.T. Speiser, Die Praxis der anodischen Oxidation des Aluminiums, Aluminium Verlag – Düsseldorf, 1977, 3. Auflage, Seiten 137 ff):
– Das Gleichstrom-Schwefelsäure-Verfahren, bei dem in einem wässrigen Elektrolyten aus üblicherweise ca. 230 g $H_2SO_4$ pro 1 l Lösung bei 10° bis 22 °C und einer Stromdichte von 0,5 bis 2,5 A/dm² während 10 bis 60 min anodisch oxidiert wird. Die Schwefelsäurekonzentration in der wässrigen Elektrolytlösung kann dabei auch bis auf 8 bis 10 Gew.-% $H_2SO_4$ (ca. 100 g $H_2SO_4$/l) verringert oder auch auf 30 Gew.-% (365 g $H_2SO_4$/l) und mehr erhöht werden.
– Die «Hartanodisierung» wird mit einem wässrigen, $H_2SO_4$ enthaltenden Elektrolyten einer Konzentration von 166 g $H_2SO_4$/l (oder ca. 230 g $H_2SO_4$/l) bei einer Betriebstemperatur von 0° bis 5 °C, bei einer Stromdichte von 2 bis 3 A/dm², einer steigenden Spannung von etwa 25 bis 30 V zu Beginn und etwa 40 bis 100 V gegen Ende der Behandlung und während 30 bis 200 min durchgeführt.

Neben den im vorhergehenden Absatz bereits genannten Verfahren zur anodischen Oxidation von Druckplatten-Trägermaterialien können beispielsweise noch die folgenden Verfahren zum Einsatz kommen: die anodische Oxidation von Aluminium in einem wässrigen $H_2SO_4$ enthaltenden Elektrolyten, dessen $Al^{3+}$-Ionengehalt auf Werte von mehr als 12 g/l eingestellt wird (nach der DE-A-2 811 396 = US-A-4 211 619), in einem wässrigen, $H_2SO_4$ und $H_3PO_4$ enthaltenden Elektrolyten (nach der DE-A-2 707 810 = US-A-4 049 504) oder in einem wässrigen, $H_2SO_4$, $H_3PO_4$ und $Al^{3+}$-Ionen enthaltenden Elektrolyten (nach der DE-A-2 836 803 = US-A-4 229 226). Zur anodischen Oxidation wird bevorzugt Gleichstrom verwendet, es kann jedoch auch Wechselstrom oder eine Kombination dieser Stromarten (z.B. Gleichstrom mit überlagertem Wechselstrom) eingesetzt werden. Die Schichtgewichte an Aluminiumoxid bewegen sich im Bereich von 1 bis 10 g/m², entsprechend einer Schichtdicke von etwa 0,3 bis 3,0 µm.

Der Stufe einer anodischen Oxidation des Druckplatten-Trägermaterials aus Aluminium können auch eine oder mehrere Nachbehandlungsstufen nachgestellt werden. Dabei wird unter Nachbehandeln insbesondere eine hydrophilierende chemische oder elektrochemische Behandlung der Aluminiumoxidschicht verstanden, beispielsweise eine Tauchbehandlung des Materials in einer wässrigen Polyvinylphosphonsäure-Lösung nach der DE-C-1 621 478 ( = GB-A-1 230 447), eine Tauchbehandlung in einer wässrigen Alkalisilikat-Lösung nach der DE-B-1 471 707 ( = US-A-3 181 461) oder eine elektrochemische Behandlung (Anodisierung) in einer wässrigen Alkalisilikat-Lösung nach der DE-A-2 532 769 ( = US-A-3 902 976). Diese Nachbehandlungsstufen dienen insbesondere dazu, die bereits für viele Anwendungsgebiete ausreichende Hydrophilie der Aluminiumoxidschicht noch zusätzlich zu steigern, wobei die übrigen bekannten Eigenschaften dieser Schicht mindestens erhalten bleiben.

Als negativ-arbeitende lichtempfindliche Reproduktionsschichten sind grundsätzlich alle Schichten geeignet, die nach dem Belichten mit einer nachfolgenden Entwicklung und gegebenenfalls Fixierung eine bildmässige Fläche liefern, von der gedruckt werden kann und/oder die ein Reliefbild einer Vorlage darstellt. Sie werden entweder beim Hersteller von vorsensibilisierten Druckplatten oder von sogenannten Trockenresists oder direkt vom Verbraucher auf eines der üblichen Trägermaterialien aufgebracht. Ausser den lichtempfindlichen Substanzen können diese Schichten selbstverständlich noch andere Bestandteile wie z.B. Harze, Farbstoffe oder Weichmacher enthalten. Insbesondere können die folgenden lichtempfindlichen Massen oder Verbindungen bei der Beschichtung der Trägermaterialien eingesetzt werden:

Negativ arbeitende Kondensationsprodukte aus aromatischen Diazoniumsalzen und Verbindungen mit aktiven Carbonylgruppen, bevorzugt Kondensationsprodukte aus Diphenylamindiazoniumsalzen und Formaldehyd, die beispielsweise in den DE-A-596 731, 1 138 399, 1 138 400, 1 138 401, 1 142 871, 1 154 123, den US-A-2 679 498 und 3 050 502 und der GB-A-712 606 beschrieben werden.

Negativ arbeitende Mischkondensationsprodukte aromatischer Diazoniumverbindungen, beispielsweise nach der DE-A-2 024 244 , die mindestens je eine Einheit der allgemeinen Typen A(—D)$_n$ und B verbunden durch ein zweibindiges, von einer kondensationsfähigen Carbonylverbindung abgeleitetes Zwischenglied aufweisen. Dabei sind diese Symbole wie folgt definiert: A ist der Rest einer mindestens zwei aromatische carbo-und/oder heterocyclische Kerne enthaltenden Verbindung, die in saurem Medium an mindestens einer Position zur Kondensation mit einer aktiven Carbonylverbindung befähigt ist. D ist eine an ein aromatisches Kohlenstoffatom von A gebundene Diazoniumsalzgruppe; n ist eine ganze Zahl von 1 bis 10; und B der Rest einer von Diazoniumgruppen freien Verbindung, die in saurem Medium an mindestens einer Position des Moleküls zur Kondensation mit einer aktiven Carbonylverbindung befähigt ist.

Negativarbeitende Schichten aus photopolymerisierbaren Monomeren, Photoinitiatoren, Bindemitteln und gegebenenfalls weiteren Zusätzen. Als Monomere werden dabei beispielsweise Acryl- und Methacrylsäureester oder Umsetzungsprodukte von Diisocyanaten mit Partialestern mehrwertiger Alkohole eingesetzt, wie es beispielsweise in den US-A-2 760 863 und 3 060 023 und den DE-A-2 064 079 und 2 361 041 beschrieben wird. Als Photoinitiatoren eignen sich u.a. Benzoin, Benzoinether, Mehrkernchinone, Acridinderivate, Phenazinderivate, Chinoxalinderivate, Chinazolinderivate oder synergistische Mischungen.

Negativ arbeitende Schichten gemäss der DE-A-3 036 077, die als lichtempfindliche Verbindung ein Diazoniumsalz-Polykondensationsprodukt oder eine organische Azidoverbindung und als Bindemittel ein hochmolekulares Polymeres mit seitenständigen Alkenylsulfonyl- oder Cycloalkenylsulfonylurethan-Gruppen enthalten.

In den folgenden Beispielen sind die %-Angaben — wenn nicht eine andere Angabe vorliegt — auf das Gewicht bezogen. Gew.-Teile verhalten sich zu Vol.-Teilen wie g zu cm$^3$.

Beispiel 1 und Vergleichsbeispiele V 1 und V 2 Ein elektrochemisch aufgerauhter und anodisch oxidierter Aluminiumträger wird mit folgender lichtempfindlicher Lösung beschichtet:

2,25 Gew.-Teile Mischpolymerisat aus Styrol und Maleinsäureanhydrid mit einem mittleren Molekulargewicht von 20.000 und der Säurezahl 180,

2,25 Gew.-Teile Polykondensationsprodukt aus 1 Mol 3-Methoxy-diphenylamin-4-diazoniumsulfat und 1 Mol 4,4'-Bis-methoxymethyl-diphenylether, in 85%iger H$_3$PO$_4$ kondensiert und als Salz der Mesitylensulfonsäure ausgefällt,

0,12 Gew.-Teile Viktoriareinblau FGA

0,30 Gew.-Teile Phosphorsäure (85%ig)

95,08 Gew.-Teile Ethylenglykolmonomethylether.

Die Schicht hat nach dem Trocknen ein Gewicht von 1,2 g/m². Nach der Belichtung unter einer 5 kW Metallhalogenid-Lampe während 25 sec wird mit einer Lösung von

30 Gew.-Teilen Na-salicylat
3 Gew.-Teilen Na$_3$PO$_4 \cdot$ 12 H$_2$O
64 Gew.-Teilen Wasser

bei einem pH-Wert von ca. 11,5 entwickelt, wonach eine einwandfreie, praxisgerechte Druckform erhalten wird. Wird statt der angegebenen Gewichtsmenge Na-salicylat das Na-Salz der 4-Hydroxybenzoesäure oder der 4-Aminobenzoesäure eingesetzt, so kann keine einwandfreie, praxisgerechte Druckform erhalten werden, d.h. es tritt keine Differenzierung der Nichtbildbereiche von den Bildbereichen auf.

**Beispiel 2**

Ein elektrochemisch aufgerauhter, anodisch oxidierter und mit einer wässrigen Polyvinylphosphonsäure-Lösung hydrophilierter Aluminiumträger wird mit folgender lichtempfindlicher Beschichtung versehen:

50,0 Gew.-Teile Umsetzungsprodukt aus einem Polyvinylbutyral (mit einem Moelkulargewicht von 80.000, enthaltend 75% Vinylbutyral-, 1% Vinylacetat- und 20% Vinylalkoholeinheiten) mit Propenylsulfonylisocyanat mit einer Säurezahl von 140

16,5 Gew.-Teile Polykondensationsprodukt nach Beispiel 1

1,5 Gew.-Teile Phosphorsäure (85%ig)
2,0 Gew.-Teile Viktoriareinblau FGA
1,0 Gew.-Teile Phenylazodiphenylamin
2500,0 Gew.-Teile Ethylenglykolmonomethylether.

Die Schicht hat nach dem Trocknen ein Gewicht von 1,0 g/m². Nach der Belichtung unter einer 5 kW-Metallhalogenid-Lampe während 25 sec wird mit einer Lösung aus

23 Gew.-Teilen Na-salicylat
8 Gew.-Teilen Na-tetrapolyphosphat
4 Gew.-Teilen $Na_3PO_4 \cdot 12 H_2O$
65 Gew.-Teilen Wasser

bei einem pH-Wert von ca. 10,3 entwickelt, wonach eine einwandfreie, praxisgerechte Druckform erhalten wird.

**Beispiel 3**

Es wird nach den Angaben des Beispiels 2 durchgeführt, aber mit einer Lösung aus

25,0 Gew.-Teilen 2-Chlorbenzoesäure
6,4 Gew.-Teilen NaOH
68,6 Gew.-Teilen Wasser

bei einem pH-Wert von ca. 10,9 entwickelt, wonach ebenfalls eine einwandfreie, praxisgerechte Druckform erhalten wird.

**Beispiel 4**

Es wird nach den Angaben des Beispiels 2 durchgeführt, aber mit einer Lösung aus

25,0 Gew.-Teilen 2-Aminobenzoesäure
7,3 Gew.-Teilen NaOH
67,7 Gew.-Teilen Wasser

bei einem pH-Wert von ca. 10,3 entwickelt, wonach ebenfalls eine einwandfreie, praxisgerechte Druckform erhalten wird.

**Beispiel 5**

Es wir nach den Angaben des Beispiels 2 durchgeführt, aber mit einer Lösung aus

51,0 Gew.-Teilen Salicylsäure
15,0 Gew.-Teilen NaOH
34,0 Gew.-Teilen Wasser,

die mit 10%iger wässriger NaOH-Lösung auf einen pH-Wert von 12,15 eingestellt wird, entwikkeltn, wonach ebenfalls eine einwandfreie, praxisgerechte Druckform erhalten wird.

**Beispiel 6**

Es wird nach den Angaben des Beispiels 2 durchgeführt, aber mit einer Lösung aus

12,0 Gew.-Teilen Na-salicylat

4,0 Gew.-Teilen Na-tetrapolyphosphat
3,0 Gew.-Teilen $Na_3PO_4 \cdot 12 H_2O$
1,0 Gew.-Teilen Na-n-octylsulfat
80,0 Gew.-Teilen Wasser

bei einem pH-Wert von ca. 8,5 entwickelt, wonach ebenfalls eine einwandfreie, praxisgerechte Druckform erhalten wird.

**Beispiel 7**

Es wird nach den Angaben des Beispiels 2 durchgeführt, aber mit einer Lösung aus

25,0 Gew.-Teilen Salicylsäure
75,0 Gew.-Teilen Wasser,

die mit Ethylendiamin auf einen pH-Wert von etwa 7,0 eingestellt wird, entwickelt, wonach ebenfalls eine einwandfreie, praxisgerechte Druckform erhalten wird.

**Vergleichsbeispiele V 3 bis V 9**

Sie werden nach den Angaben des Beispiels 2 durchgeführt, aber es wird jeweils mit einer Lösung entwickelt, die statt Na-salicylat das Na-salz der 4-Aminobenzoesäure (V 3), der 3-Aminobenzoesäure (V 4), der 4-Hydroxybenzoesäure (V 5), der 3-Hydroxybenzoesäure (V 6), der 4-Methoxybenzoesäure (V 7), der 2-Methoxybenzoesäure (V 8) oder der Benzoesäure (V 9) enthält. In keinem Fall kann eine einwandfreie, praxisgerechte Druckform erhalten werden, d.h. es tritt keine ausreichende Differenzierung der Nichtbildbereiche von den Bildbereichen auf.

**Beispiel 8**

Ein elektrochemisch aufgerauhter und anodisch oxidierter Aluminiumträger wird mit folgender lichtempfindlicher Beschichtung versehen:

1,40 Gew.-Teile eines Polyesters, dessen freie OH-Gruppen mit Acrylsäure verestert sind

1,40 Gew.-Teile Mischpolymerisat aus Methylmethacrylat und Methacrylsäure mit einem mittleren Molekulargewicht von 60.000 und einer Säurezahl von 93,7

0,10 Gew.-Teile 9-Phenyl-acridin
0,20 Gew.-Teile 1,6-Dihydroxyethoxy-hexan
0,02 Gew.-Teile Supranolblau G1 (C. I. 50 335)
13,00 Gew.-Teile Ethylenglykolmonomethylether.

Die Schicht wird nach dem Trocknen bildmässig belichtet und mit einer Lösung aus

50 Gew.-Teilen Na-salicylat
50 Gew.-Teilen Wasser,

die mit 10%iger wässriger NaOH-Lösung auf einen pH-Wert von etwa 11,0 eingestellt wird, entwickelt wonach eine einwandfreie, praxisgerechte Druckform erhalten wird.

**Beispiel 9**

Ein elektrochemisch aufgerauhter, anodisch oxidierter und mit einer wässrigen Polyvinylphosphonsäure-Lösung hydrophilierter Aluminiumträger wird mit folgender lichtempfindlicher Beschichtung versehen:

1,60 Gew.-Teile Polyvinylformal
0,50 Gew.-Teile Polykondensationsprodukt nach Beispiel 1

0,05 Gew.-Teile $H_3PO_4$ (85%ig)

0,30 Gew.-Teile Hostapermblau

57,00 Gew.-Teile Ethylenglykolmonomethylether

30,00 Gew.-Teile Tetrahydrofuran

8,00 Gew.-Teile Butylacetat

Die Schicht wird nach dem Trocknen bildmässig belichtet und mit einer Lösung aus

21 Gew.-Teilen Na-salicylat

8 Gew.-Teilen Na-tetrapolyphosphat

4 Gew.-Teilen $Na_3PO_4 \cdot 12 H_2O$

67 Gew.-Teilen Wasser

bei einem pH-Wert von 7,45 entwickelt, wonach eine einwandfreie, praxisgerechte Druckform erhalten wird.

Beispiel 10

Ein elektrochemisch aufgerauhter, anodisch oxidierter und mit einer wässrigen Lösung von Polyvinylphosphonsäure hydrophilierter Aluminiumträger wird mit folgender lichtempfindlicher Lösung beschichtet:

1,0 Gew.-Teile Polykondensationsprodukt nach Beispiel 1

1,8 Gew.-Teile nichtplastifiziertes Harnstoffharz (mit einer Viskosität in 65%iger Lösung in Butanol/Xylol bei 20°C von ca. 6.000 mPas und einer Säurezahl unterhalb 3)

0,4 Gew.-Teile Kristallviolett

98,0 Gew.-Teile Ethylenglykolmonomethylether.

Die Schicht wird nach dem Trocknen während 4 sec unter einer 5 kW Metallhalogenid-Lampe bildmässig belichtet und mit der Lösung nach Beispiel 8 entwickelt, wonach eine einwandfreie, praxisgerechte Druckform erhalten wird.

## Patentansprüche

1. Wässriger Entwickler zum Entwickeln lichtempfindlicher negativ-arbeitender, gegebenenfalls ein organisches Bindemittel enthaltender Reproduktionsschichten mit einer lichtempfindlichen Substanz auf der Basis eines Diazoniumsalz-Polykondensationsproduktes oder eines polymeren Acrylsäure- oder Methacrylsäurederivates, dadurch gekennzeichnet, dass der Entwickler neben Wasser 5 bis 60 Gew.-% mindestens eines Salzes von aromatischen Carbonsäuren enthält, deren Substituenten unmittelbar der Carboxylgruppe benachbart sind, wobei die Substituenten eine Aminogruppe, eine Hydroxygruppe und/oder Chlor oder Brom darstellen und der Entwickler frei von organischen Lösemitteln ist.

2. Entwickler nach Anspruch 1, dadurch gekennzeichnet, dass er 10 bis 30 Gew.-% mindestens eines Salzes der aromatischen Carbonsäuren enthält.

3. Entwickler nach Anspruch 1 oder 2, dadurch gekennzeichnet, dass er ein Salz der 2-Hydroxybenzoesäure, 2-Aminobenzoesäure, 2-Chlorbenzoesäure, 2,6-Dihydroxybenzoesäure und/oder 2-Hydroxy-naphthalin-3-carbonsäure enthält.

4. Entwickler nach einem der Ansprüche 1 bis 3, dadurch gekennzeichnet, dass er 0,01 bis 10 Gew.-% eines anionogenen Tensids enthält.

5. Verfahren zum Entwickeln von lichtempfindlichen, negativ-arbeitenden, gegebenenfalls ein organisches Bindemittel enthaltenden Reproduktionsschichten mit einer lichtempfindlichen Substanz auf der Basis eines Diazoniumsalz-Polykondensationsproduktes oder eines polymeren Acrylsäure- oder Methacrylsäurederivates, wobei man die Schicht belichtet und anschliessend entwickelt, dadurch gekennzeichnet, dass man die Reproduktionsschicht mit einem Entwickler behandelt, der neben Wasser 5 bis 60 Gew.-% mindestens eines Salzes von aromatischen Carbonsäuren enthält, deren Substituenten unmittelbar der Carboxylgruppe benachbart sind, wobei die Substituenten eine Aminogruppe, eine Hydroxygruppe und/oder Chlor oder Brom darstellen und der Entwickler frei von organischen Lösemitteln ist.

6. Verfahren nach Anspruch 5, dadurch gekennzeichnet, dass die Reproduktionsschicht ein polymeres organisches Bindemittel mit Acetal-, Anhydrid-, Amid- und/oder Carboxylgruppen enthält.

7. Verfahren nach Anspruch 5 oder 6, dadurch gekennzeichnet, dass die Reproduktionsschicht als lichtempfindliche Verbindung ein Diazoniumsalz-Polykondensationsprodukt enthält.

## Claims

1. An aqueous developer for developing light-sensitive, negative-working reproduction layers which contain a light-sensitive substance based on a diazonium salt polycondensation product or a polymeric derivative of acrylic or methacrylic acid and which optionally contain an organic binder, said developer containing, apart from water, 5 to 60% by weight of at least one salt of aromatic carboxylic acids, the substituents of which are immediately adjacent to the carboxyl group and represent an amino group, a hydroxyl group and/or chlorine or bromine, and being free from organic solvents.

2. The developer as claimed in claim 1, which contains 10 to 30% by weight of at least one salt of the aromatic carboxylic acids.

3. The developer as claimed in claim 1 or 2, which contains a salt of 2-hydroxybenzoic acid, 2-amino benzoic acid, 2-aminobenzoic acid, 2-chlorobenzoic acid, 2,6-dihydroxybenzoic acid and/or 2-hydroxynaphthalene-3-carboxylic acid.

4. The developer as claimed in any of claims 1 to 3, which contains 0.01 to 10% by weight of an anionic surfactant.

5. A process for developing light-sensitive, negative-working reproduction layers which contain a light-sensitive substance based on a diazonium salt polycondensation product or a polymeric derivative of acrylic or methacrylic acid and which optionally contain an organic binder, which process comprises exposing an subsequently developing the layer, whereby the reproduction layer is treated with a developer contains, apart from water, 5 to 60% by weight of at least one salt of aromatic caroxylic acids, the substituents of which are immediately adjacent to the carboxyl group and represent an amino group, a hydroxyl group and/or chlorine or bromine, and is free from organic solvents.

6. The process as claimed in claim 5, wherein the reproduction layer contains a polymeric organic binder with acetal, anhydride, amine and/or carboxyl groups.

7. The process as claimed in claim 5 or 6, wherein the reproduction layer contains, as the light-sensitive compound, a diazonium salt polycondensation product.

## Revendications

1. Révélateur aqueux pour le développement de couches de reproduction photosensibles, travaillant en négatif, contenant éventuellement un liant organique, qui comportent une substance photosensible à base d'un produit de polycondensation de sel de diazonium ou d'un polymère dérivé de l'acide acrylique ou de l'acide méthacrylique, caractérisé en ce que le révélateur contient, en plus d'eau, 5 à 60% en poids d'au moins un sel d'acides carboxyliques aromatiques dont les substituants sont au voisinage immédiat du groupe carboxy, les substituants représentant un groupe amino, un groupe hydroxy et/ou un atome de chlore ou de brome, et le révélateur étant exempt de solvants organiques.

2. Révélateur selon la revendication 1, caractérisé en ce qu'il contient de 10 à 30% en poids d'au moins un sel des acides carboxyliques aromatiques.

3. Révélateur selon la revendication 1 ou 2, caractérisé en ce qu'il contient un sel de l'acide 2-hydroxybenzoïque, de l'acide 2-aminobenzoïque, de l'acide 2-chlorobenzoïque, de l'acide 2,6-dihydroxybenzoïque et/ou de l'acide 2-hydroxy-naphthalène-3-carboxylique.

4. Révélateur selon l'une des revendications 1 à 3, caractérisé en ce qu'il contient de 0,01 à 10% en poids d'un surfactif anionique.

5. Procédé pour le développement de couches de reproduction photosensibles travaillant en négatif, contenant éventuellement un liant organique, comportant une substance photosensible à base d'un produit de condensation de sel de diazonium ou d'un polymère dérivé de l'acide acrylique ou de l'acide méthacrylique, dans lequel on expose la couche et on la développe ensuite, caractérisé en ce que l'on traite la couche de reproduction avec un révélateur qui contient, en plus d'eau, 5 à 60% en poids d'au moins un sel d'acides carboxyliques aromatiques dont les substituants se trouvent immédiatement au voisinage du groupe carboxy, les substituants représentant un groupe amino, un groupe hydroxy et/ou un atome de chlore ou de brome, et le révélateur étant exempt de solvants organiques.

6. Procédé selon la revendication 5, caractérisé en ce que la couche de reproduction contient un liant organique polymère comportant des groupes acétal, anhydride, amide et/ou carboxy.

7. Procédé selon la revendication 5 ou 6, caractérisé en ce que la couche de reproduction contient en tant que composé photosensible un produit de polycondensation à base de sel de diazonium.